# EUROPEAN PATENT APPLICATION

(11) **EP 1 865 536 A2**
(43) Date of publication of application: **12.12.2007**
(21) Application number: 07109099.7
(22) Date of filing: 29.05.2007
(51) Int. Cl.: H01L 21/00

(54) **Peeling tape adhering method and peeling tape adhering device**

(30) Priority: 08.06.2006 JP 2006159617
(71) Applicant: TOKYO SEIMITSU CO., LTD., Mitaka-shi Tokyo (JP)
(72) Inventor: Kawashima, Isamu Tokyo Seimitsu Co., Ltd., Mitaka-shi Tokyo (JP); Sato, Hideshi Tokyo Seimitsu Co., Ltd., Mitaka-shi Tokyo (JP); Kino, Hideo Tokyo Seimitsu Co., Ltd., Mitaka-shi Tokyo (JP); Ametani, Minoru Tokyo Seimitsu Co., Ltd., Mitaka-shi Tokyo (JP)
(74) Representative: Skone James, Robert Edmund

(57) **Abstract**

A peeling tap adhering method for adhering a peeling tape (4) to a surface protection film (11) adhered to the front surface of a wafer (20), comprises the steps of: supporting the wafer on a table (31) under the condition that the surface protection film is directed upward; adhering the peeling tape onto the surface protection film by pressing the peeling tape onto the surface protection film when a peeling tape adhering means (46) is lowered; detecting the pressure between the surface protection film of the wafer and the peeling tape adhering means; and stopping the peeling tape adhering means from lowering in the case where a pressure detection value (P) is not less than a predetermined value (P0). Due to the foregoing, it is possible to prevent the wafer from being cracked. Further, it is possible to prevent the peeling tape and the dicing tape from adhering to each other. When the distance (L) between the surface protection film of the wafer and the peeling tape adhering means becomes a value not more than a predetermined value (L0), the peeling tape sticking means may be stopped from lowering.

## Description

### BACKGROUND OF THE INVENTION

### 1. Field of the Invention

The present invention relates to a peeling tape adhering method for adhering a peeling tape to a surface protective film adhered on a wafer. The present invention also relates to a peeling tape adhering device for carrying out this peeling tape adhering method.

### 2. Description of the Related Art

In the field of manufacturing semiconductors, there is a tendency for large-sized wafers to be used year after year. Further, in order to enhance the packing density, the wafer thickness is reduced. In order to reduce the wafer thickness, back-grinding is conducted on the back surface of a semiconductor wafer. At the time of back-grinding, in order to protect a semiconductor element formed on the front surface of a wafer, a surface protection film is adhered to the front surface of the wafer.

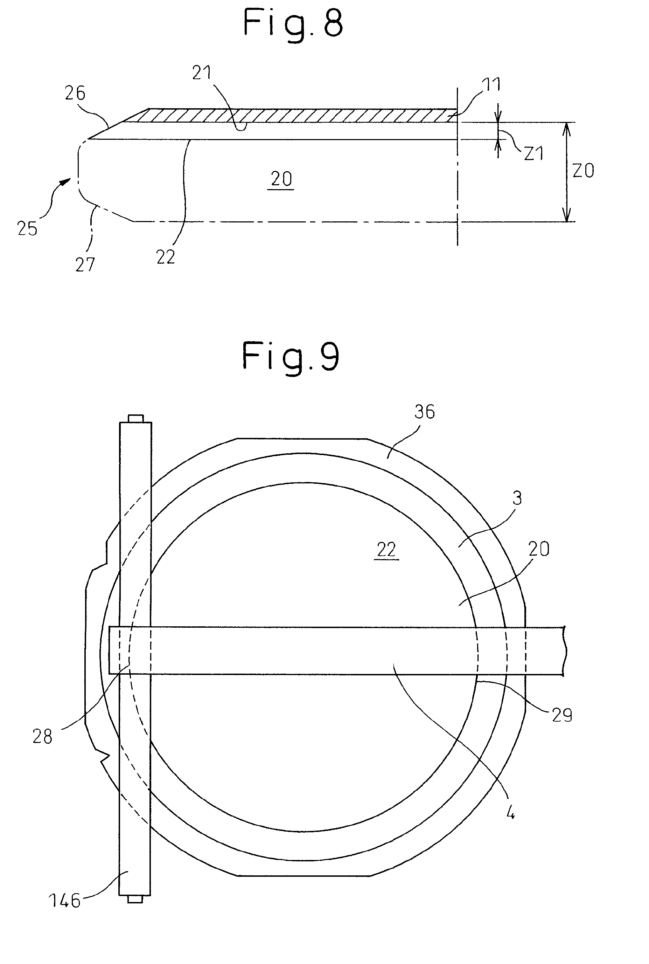

Fig. 8 is an enlarged sectional view showing a circular wafer onto which a surface protection film is adhered. As can be seen from Fig. 8, an edge portion of 25 of the circular wafer 20 is chamfered in the beginning. A surface protection film 11 is adhered to a front surface 21 of the wafer 20. As shown in the drawing, a back surface of the wafer 20 is ground, that is, back-grinding is conducted on the back surface of the wafer 20. When the thickness of the wafer 20 is reduced from thickness Z0 to thickness Z1, a chamfered portion 27 on the back surface side of the wafer 20 is eliminated. Therefore, the newly formed back surface 22 (a ground surface) of a wafer 20 reaches a chamfered portion 26 on the front surface side.

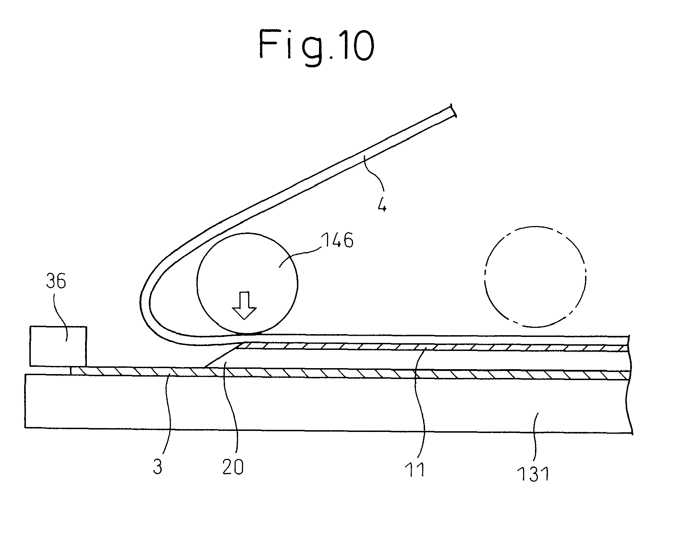

Next, as shown in Fig. 9, a dicing tape 3 is adhered to the back surface 22 of the wafer 20. Due to this dicing tape 3, the wafer 20 is integrated with a mount frame 36 into one body. Concerning this matter, refer to Japanese Unexamined Patent Publication No. 2003-124146. After that, the wafer 20 is supported on a table 131 in such a manner that the surface protection film 11 is located upward as shown in Fig. 10. After a peeling tape 4 has been drawn out on the surface protection film 11, a peeling roller 146 is pressed onto the surface protection film 11, so that the peeling tape 4 can be adhered to the surface protection film 11. Next, by moving the table 131 for supporting the wafer 20 in the horizontal direction, the surface protection film 11 is peeled from the wafer 20 together with the peeling tape 4.

As described before, since the wafer 20 has been greatly reduced in thickness in recent years, the rigidity of the wafer itself is also greatly reduced. Accordingly, when the peeling tape 4 is adhered to the surface protection film 11 by the peeling roller 146, there is a possibility that fractures or cracks are formed on the wafer 20, which decreases yield. Even when no fractures or cracks are generated, internal strain may be generated on the wafer 20. Thus, there is a possibility that fractures or cracks will appear on the wafer in the next step due to internal strain.

Further, since the wafer 20 is greatly reduced in thickness, when the peeling roller 146 is strongly pressed in the case of adhering the peeling tape 4 to the wafer 20, there is a high possibility that the peeling tape 4 will hang down as shown in Fig. 10 and adhere to the dicing tape 3. In this case, the adhesive faces of the tapes 3, 4 adhere to each other. Accordingly, when these tapes 3, 4 once adhered to each other, they become difficult to separate from each other without causing damage to the wafer 20.

The present invention has been accomplished in view of the above circumstances. It is an object of the present invention to provide a peeling tape adhering method capable of preventing the generation of fractures or cracks on a wafer and also capable of preventing the adhesion between a peeling tape and a dicing tape. It is another object of the present invention to provide a peeling tape adhering device for executing this peeling tape adhering method.

### SUMMARY OF THE INVENTION

In order to accomplish the above object, according to the first aspect, a peeling tape adhering method for adhering a peeling tape to a surface protection film adhered to a front surface of a wafer comprises the steps of: supporting the wafer on a table under the condition that the surface protection film is directed upward; adhering the peeling tape onto the surface protection film of the wafer by pressing the peeling tape onto the surface protection film when a peeling tape adhering means is lowered; detecting pressure between the surface protection film of the wafer and the peeling tape adhering means; and stopping the peeling tape adhering means from lowering in the case where a detected pressure value is not less than a predetermined value.

According to the second aspect, a peeling tape adhering device for adhering a peeling tape to a surface protection film adhered to a front surface of a wafer, comprises: a table for supporting the wafer while the surface protection film is being directed upward; a peeling tape adhering means for pressing and adhering the peeling tape onto the surface protection film of the wafer; and a pressure detection means for detecting pressure between the surface protection film on the wafer and the peeling tape adhering means, wherein when the peeling tape is pressed and adhered to the surface protection film by lowering the peeling tape adhering means, in the case where a pressure value detected by the pressure detection means is not less than a predetermined value, the peeling tape adhering means is stopped from lowering.

In the first and the second aspect, when the pressure generated between the surface protection film and the peeling tape adhering means is raised to a value higher than a predetermined value, the peeling tape adhering means is stopped from lowering. Therefore, it is possible to prevent fractures or cracks from being formed on the entire wafer. In the case where the wafer and the mount frame are integrated with each other into one body, it is not necessary to use excessive force to press the peeling tape adhering means. Therefore, it is possible to prevent the peeling tape and the dicing tape from adhering to each other. Further, since the pressing force applied to the peeling tape can be directly controlled, even in the case where the thickness of the wafer and/or the thickness of the surface protection film is different, the peeling tape can be adhered by the same amount of pressing force.

According to the third aspect, as in the second aspect, the pressure detection means is incorporated into a portion of the peeling tape adhering means coming into contact with the surface protection film.

In the third aspect, pressure generated between the surface protection film and the peeling tape adhering means can be directly detected. Therefore, pressing of the peeling tape can be finished at the correct timing.

According to the fourth aspect, as in the second embodiment, the pressure detection means is incorporated into a portion of the table located corresponding to the peeling tape adhering means.

In the fourth aspect, it is possible to ensure a sufficiently large space for installing a pressure detection means. Accordingly, a relatively large pressure detection means having high performance can be installed.

According to the fifth aspect, a peeling tape adhering method for adhering a peeling tape to a surface protection film adhered to a front surface of a wafer, comprises the steps of: supporting the wafer on a table under the condition that the surface protection film is directed upward; adhering the peeling tape to the surface protection film of the wafer by pressing the peeling tape onto the surface protection film when a peeling tape adhering means is lowered; detecting a distance between the surface protection film of the wafer and the peeling tape adhering means; and stopping the peeling tape sticking means from lowering in the case where a detected distance value is not more than a predetermined value.

According to the sixth aspect, a peeling tape adhering device for adhering a peeling tape to a surface protection film adhered to a front surface of a wafer, comprises: a table for supporting the wafer while the surface protection film is being directed upward; a peeling tape adhering means for pressing and adhering the peeling tape to the surface protection film on the wafer; and a distance detection means for detecting a distance between the surface protection film of the wafer and the peeling tape adhering means, wherein when the peeling tape is pressed and adhered to the surface protection film by lowering the peeling tape adhering means, in the case where a distance value detected by the distance detection means is not more than a predetermined value, the peeling tape sticking means is stopped from lowering.

In the fifth and the sixth aspect, when the distance between the surface protection film and the peeling tape adhering means is reduced to a value not more than a predetermined value, the peeling tape adhering means is stopped from lowering. Therefore, it is easy to prevent fractures or cracks from being form on the entire wafer. Further, even in the case where the wafer is integrated with a mount frame into one body, the peeling tape adhering means is not pressed excessively. Therefore, it is possible to prevent the peeling tape and the dicing tape from adhering to each other. In this connection, the predetermined value of the distance is a value a little higher than zero. Alternatively, the predetermined value of the distance may be zero. Further, since the pressing force given by the peeling tape can be directly controlled, even in the case where the thickness of the wafer and/or the thickness of the surface protection film is different, the peeling tape can be adhered by the same amount of pressing force.

These and other objects, features and advantages of the present invention will be more apparent in light of the detailed description of exemplary embodiments thereof as illustrated by the drawings.

### BRIEF DESCRIPTION OF THE DRAWINGS

In the drawings:
Fig. 1 is a side view showing an outline of a surface protection film peeling device having a peeling tape adhering unit of the present invention;
Fig. 2 is a top view briefly showing a peeling tape adhering unit of the present invention;
Fig. 3 is a flow chart showing an operation program of a surface protection film peeling device having a peeling tape adhering unit of the first embodiment of the present invention;
Fig. 4a is a first view for explaining operation of a surface protection film peeling device having a peeling tape adhering unit of the present invention;
Fig. 4b is a second view for explaining operation of a surface protection film peeling device having a peeling tape adhering unit of the present invention;
Fig. 5a is a third view for explaining operation of a surface protection film peeling device having a peeling tape adhering unit of the present invention;
Fig. 5b is a fourth view for explaining operation of a surface protection film peeling device having a peeling tape adhering unit of the present invention;
Fig. 6 is a partial enlarged view showing a peeling tape adhering unit of another embodiment of the present invention;
Fig. 7 is a flow chart showing an operation program of a surface protection film peeling device having a peeling tape adhering unit of the second embodiment of the present invention;
Fig. 8 is an enlarged sectional view of a wafer onto which a surface protection film is adhered;
Fig. 9 is a top face view showing a wafer integrated with a mount frame; and
Fig. 10 is a sectional view showing a state in which a peeling tape is adhered to a surface protection film on a wafer of the prior art.

### DETAILED DESCRIPTION OF THE PREFERRED EMBODIMENTS

Referring to the accompanying drawings, an embodiment of the present invention will be explained below. Like reference numerals are used to indicate like parts in the following drawings. In order to facilitate understanding, the reduced scale of these drawings has been appropriately changed.

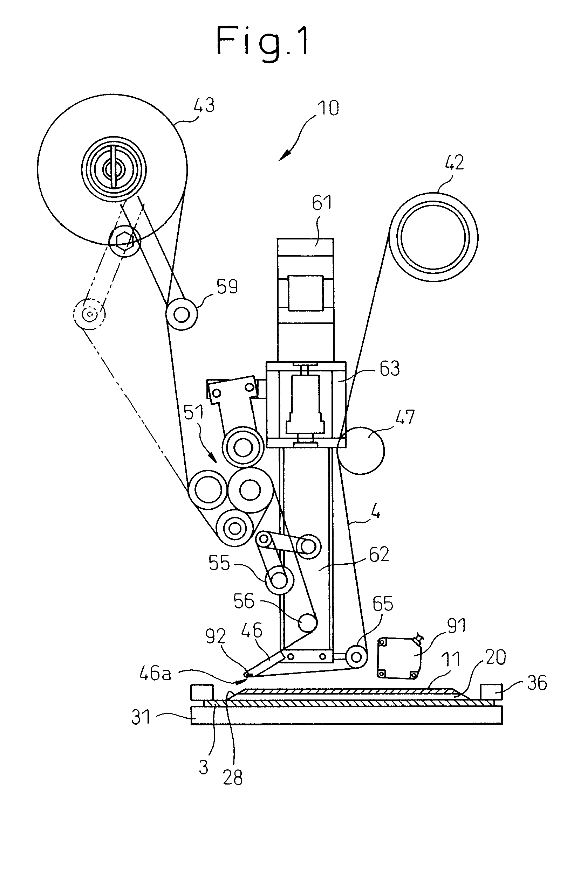

Fig. 1 is a schematic illustration showing a surface protection film peeling device according to the present invention. A back surface of a wafer 20, which is supplied to the surface protection film peeling device 10, is ground to a chamfered portion 26 on a front surface side by the method of back-grinding. For example, the wafer 20 is not more than 100 micrometers thick. As well known, a surface protection film 11 for protecting a circuit pattern has already been adhered to the front surface of a wafer 20. Further, as explained before referring to Fig. 9, a dicing tape 3 is adhered to a grinding surface 22 of the wafer 20. Therefore, the wafer 20 is integrated with a mount frame 36 into one body by the dicing tape 3.

The surface protection film peeling device 10 shown in Fig. 1 includes: a supply portion 42 for supplying a peeling tape 4 to be adhered onto the surface protection film 11 on the wafer 20; and a winding portion 43 for winding the peeling tape 4 sent from the supply portion 42. The peeling tape 4, which will be explained below, is a so-called pressure sensitive tape, which exhibits an adhesion action when the tape is given pressure. Alternatively, the peeling tape may be a so-called heat sensitive tape, which exhibits an adhesion action when heated.

As shown in Fig. 1, in the downstream of the supply portion 42, guide rollers 47, 65 are arranged for guiding the peeling tape 4 and for giving a predetermined tension to the peeling tape 4. The peeling tape 4 passes through an adhering member 46 of the surface protection film peeling device 10 and is guided to the winding portion 43. As shown in the drawing, a cross section of the tip portion of the adhering member 46 is a rectangle or a triangle. This adhering member 46 is arranged in a direction so that the tip portion of the sticking member 46 can be contacted with the wafer 20 in a small area. There are provided a guide roller 56, a dancer roller 55, a pair of guide rollers 51 and other dancer rollers 59 between the adhering member 46 and the winding portion 43. These dancer rollers 55, 59 are operated according to an amount of the peeling tape 4 which has been drawn out.

A peeling tape adhering unit 60 of the surface protection film peeling device 10 has a shaft 62 inserted into a cover guide portion 63. A motor 61 is attached to an upper portion of the cover guide portion 63. As shown in the drawing, the adhering member 46 is arranged at a bottom end portion of the shaft 62. The guide rollers 56, 65 related to the adhering member 46 are arranged at predetermined positions of the shaft 62. Accordingly, when the shaft 62 is elevated and lowered along the cover guide portion 63 by the motor 61, the adhering member 46 and the guide rollers 56, 65 are integrally elevated and lowered. In this connection, it is possible to employ an air cylinder for elevating and lowering the shaft 62 instead of the motor.

Below the adhering member 46, a support table 31 is provided which supports the wafer 20 and the mount frame 36. This support table 31 can be moved in the horizontal direction, that is, this support table 31 can be moved in the lateral direction in Fig. 1. A distance sensor 91 arranged behind the guide roller 65 detects the distance between the surface protection film 11 on the wafer 20 supported by the support table 31 and the tip portion 46a of the adhering member 46.

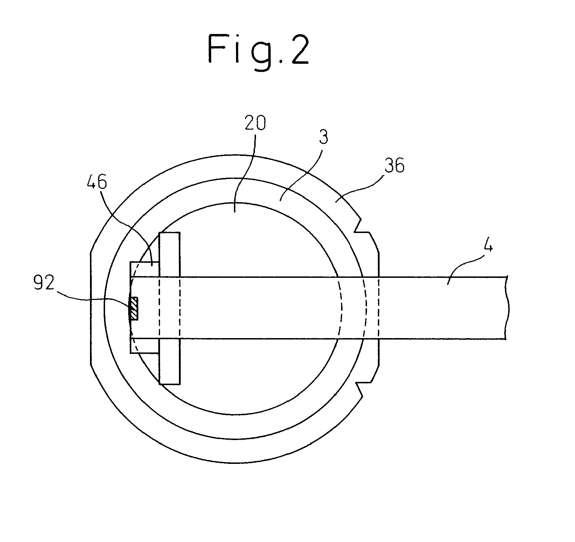

As shown in Fig. 1, a pressure sensor 92, for example, a sheet-type pressure sensor is arranged at a tip portion 46a of the adhering member 46. Fig. 2 is a top view briefly showing the peeling tape adhering unit of the present invention. As can be seen from Figs. 1 and 2, the pressure sensor 92 is embedded in a portion of the adhering member 46 coming into contact with the wafer 20. To be specific, the pressure sensor 92 is embedded in the adhering member 46 in such a manner that a pressure detection face of the pressure sensor 92 can be on the same plane as that of the portion of the adhering member 46 coming into contact with the wafer 20.

Accordingly, the pressure sensor 92 can detect pressure generated between the adhering member 46 and the surface protection film 11 at the time of pressing the adhering member 46 to the surface protection film 11. The embedded pressure sensor 92 is advantageous for directly detecting the pressure generated between the adhering member 46 and the surface protection film 11.

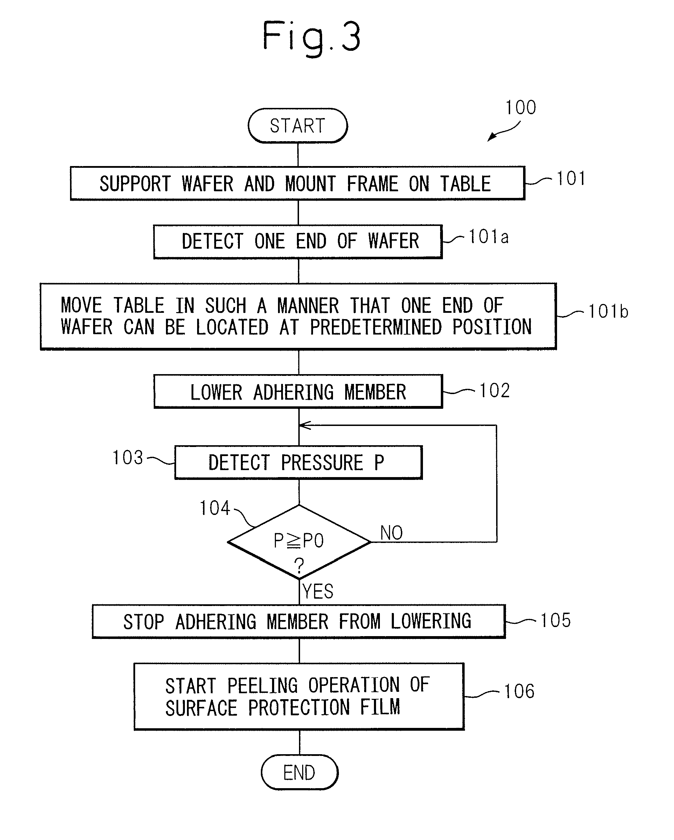

Fig. 3 is a flow chart showing an operation program of the surface protection film peeling device having the peeling tape adhering unit of the first embodiment of the present invention. This operation program is incorporated into a memory of a control portion 95 (not shown) and executed by the control portion 95. In this connection, each element of the surface protection film peeling device 10 is connected to and controlled by the control portion 95.

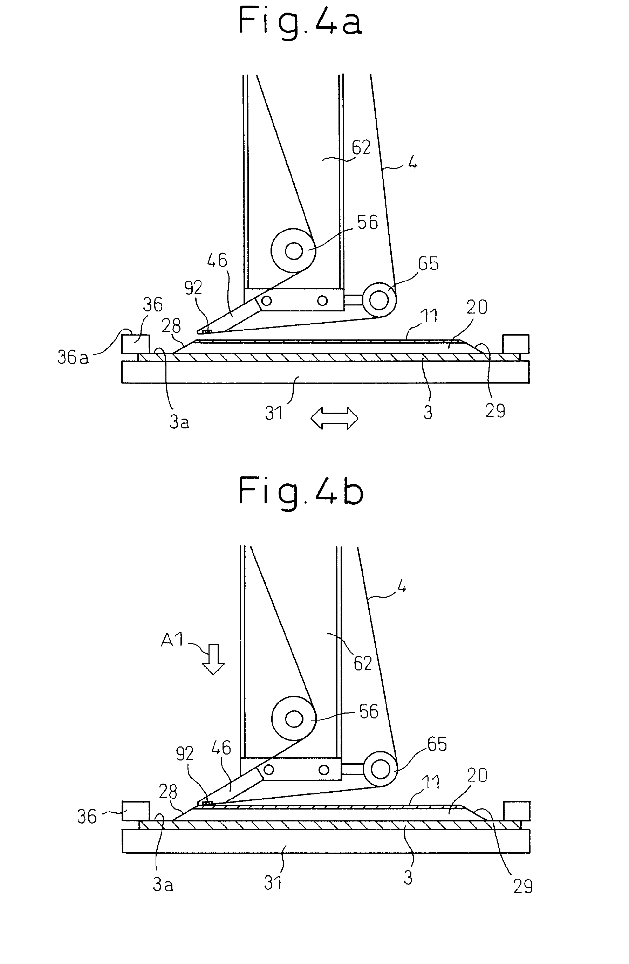

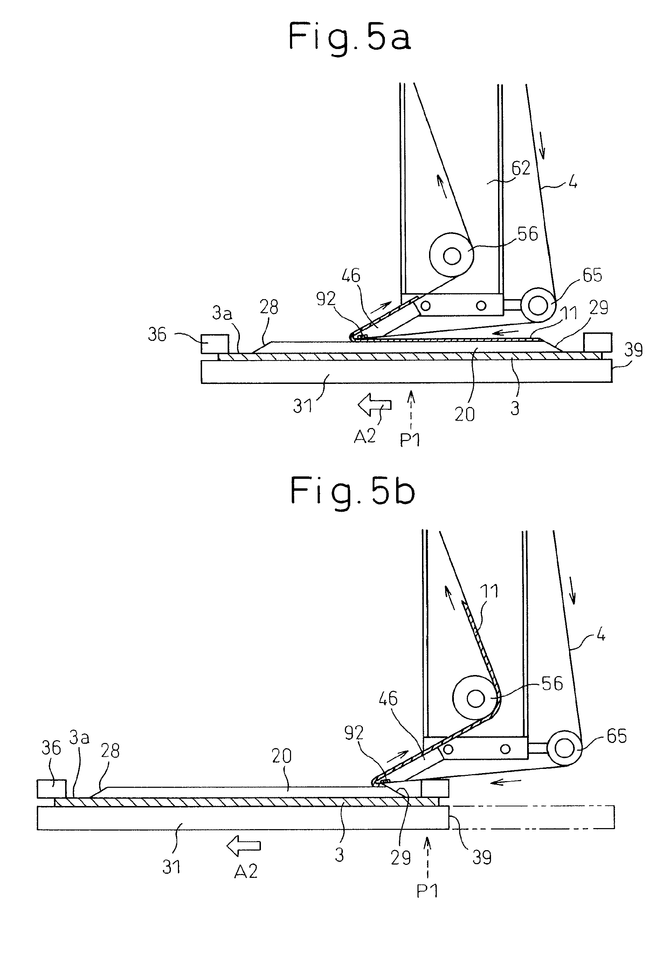

Figs. 4a, 4b, 5a and 5b are views explaining the operation of the surface protection film peeling device with the peeling tape adhering unit 60 of the present invention. So as to simplify the explanation, the distance sensor 91 is omitted from these drawings.

Referring to the drawings, the operation of the surface protection film peeling device 10 of the present invention will be explained below. In this connection, before the surface protection film peeling device 10 is driven, the peeling tape 4 has already been drawn out from the supply portion 42 to the winding portion 43 through the adhering member 46.

In step 101 of the operation program 100 shown in Fig. 3, the wafer 20 and the mount frame 36, which have been integrated with each other by the dicing tape 3, are supported on the support table 31.

Next, in step 101a, a position of the wafer 20 on the support table 31 is detected by a sensor (not shown). In particular, the position of one end 28 of the wafer 20 is detected by the sensor (not shown). After that, in step 101b, the support table 31 is moved in the horizontal direction so that the adhering member 46 is located on one end 28 of the wafer 20. Concerning this matter, refer to Fig. 4a. Alternatively, the support table 31 may be previously positioned at such a position before the wafer 20 is supported.

Next, in step 102, the motor 61 is driven and the shaft 62 and the adhering member 46 are slid in the cover guide portion 63 so that the shaft 62 and the adhering member 46 can be integrally lowered. Concerning this matter, refer to arrow A1 in Fig. 4b. Due to the foregoing, the adhering member 46 presses the peeling tape 4 onto the surface protection film 11 on the wafer 20.

Simultaneously, in step 103, when the adhering member 46 presses the peeling tape 4 onto the surface protection film 11 on the wafer 20, pressure P generated between the surface protection film 11 on the wafer 20 and the adhering member 46 is detected by the pressure sensor 92. Next, in step 104, the thus detected pressure P is compared with a predetermined value P0. The predetermined value P0 is a value at which fractures or cracks or internal strain is not generated on the wafer 20. This predetermined value P0 is previously found through experiments etc. and stored in the memory of the control portion 95.

In the case where it is determined that the detected pressure P is not less than the predetermined value P0, the program proceeds to step 105 and the adhering member 46 is stopped from lowering and maintained at the same height. On the other hand, in the case where it is determined that the detected pressure P is not more than the predetermined value P0, the program returns to step 103 and the processing is repeated until the pressure P becomes a value not less than the predetermined value P0.

As described above, in the first embodiment of the present invention, the predetermined value P0, at which no fractures or cracks are generated, is previously determined. In the case where pressure P is raised to a value not less than the predetermined value P0, the adhering member 46 is stopped from lowering, so that the pressing force given by the adhering member 46 cannot be increased anymore. Therefore, it is possible to prevent the wafer 20 from generating fractures or cracks. Especially, it is possible to prevent the end portion 28 of the wafer 20 from generating fractures or cracks. Further, it is possible to prevent the generation of internal strain on the wafer 20.

As shown in the drawing, even in the case where the wafer 20 and the mount frame 36 are integrated with each other into one body, it is not necessary to use excessive force to press the adhering member 46 in the first embodiment of the present invention. Therefore, the peeling tape 4 does not hang down. Accordingly, it is possible to prevent the peeling tape 4 and the dicing tape 3 from adhering to each other. Further, in the first embodiment of the present invention, since the pressing force given to the peeling tape 4 can be directly controlled. In the case where the thickness of the wafer 20 after the completion of back-grinding and/or the thickness of the surface protection film 11 is different, the peeling tape 4 can be adhered by the same pressing force.

Referring to Fig. 3 again, in step 106 shown in the operation program 100, peeling operation of the surface protection film 11 is started. To be specific, as shown by arrow A2 in Fig. 5a, the support table 31 is horizontally moved from the other end 29 of the wafer toward the one end 28. At the same time, the peeling tape 4 is drawn out from the supply portion 42 and wound up by the winding portion 43. Due to the foregoing, a portion, at which the peeling tape 4 is adhered, functions as a peeling starting portion. Therefore, the surface protection film 11 is gradually peeled off from the peeling starting portion at one end 28 of the wafer 20.

Next, when the rear end 39 of the support table 31 is moved to the predetermined position P1 shown in Figs. 5a and 5b, it is determined that the surface protection film 11 has been completely peeled off from the entire face of the wafer 20. Accordingly, when a sensor (not shown) detects that the rear end 39 of the support table 31 has moved to position P1, the peeling tape 4 and the support table 31 stop. In this way, the peeling operation made by the surface protection film peeling device 10 is finished.

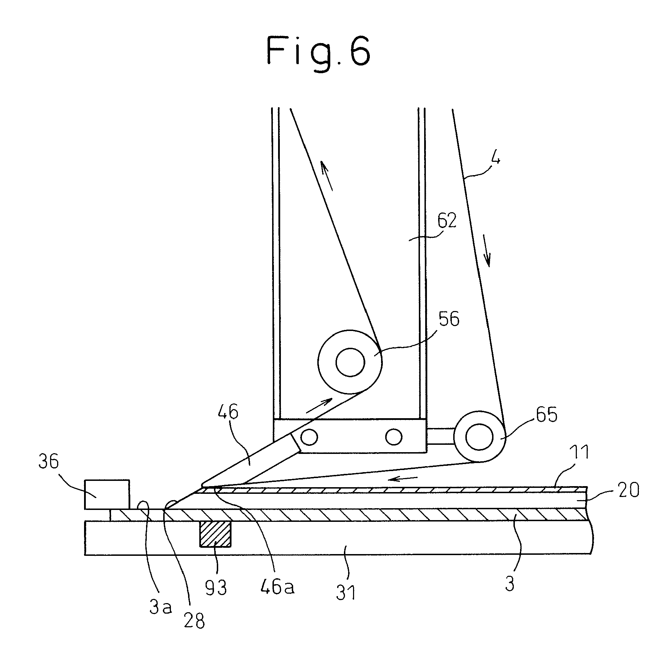

Fig. 6 is a partial enlarged view showing a peeling tape adhering unit of another embodiment of the present invention. In Fig. 6, the pressure sensor 92 embedded in the adhering member 46 is excluded. Instead of the pressure sensor 92, another pressure sensor 93 is arranged on the support table 31. As shown in the drawing, the pressure sensor 93 is embedded in the support table 31 at a position corresponding to the tip portion 46a of the adhering member 46 which presses the peeling tape 4 onto the surface protection film 11. In a case, in which the pressure sensor 93 is embedded in the support table 31, is compared with a case, in which the pressure sensor 93 is embedded in the adhering member 46, it is possible to ensure a large space. Therefore, in the embodiment shown in Fig. 6, it is possible to arrange a relatively large pressure sensor having high performance.

The peeling tape 4, the surface protection film 11, the wafer 20 and the dicing tape 3 are interposed between the adhering member 46 and the pressure sensor 93. Therefore, strictly speaking, pressure P' detected in another embodiment shown in Fig. 6 is different from pressure P described before. However, even in the case where pressure P' is employed, the substantially same advantages as those described before can be provided through the operation program 100 shown in Fig. 3.

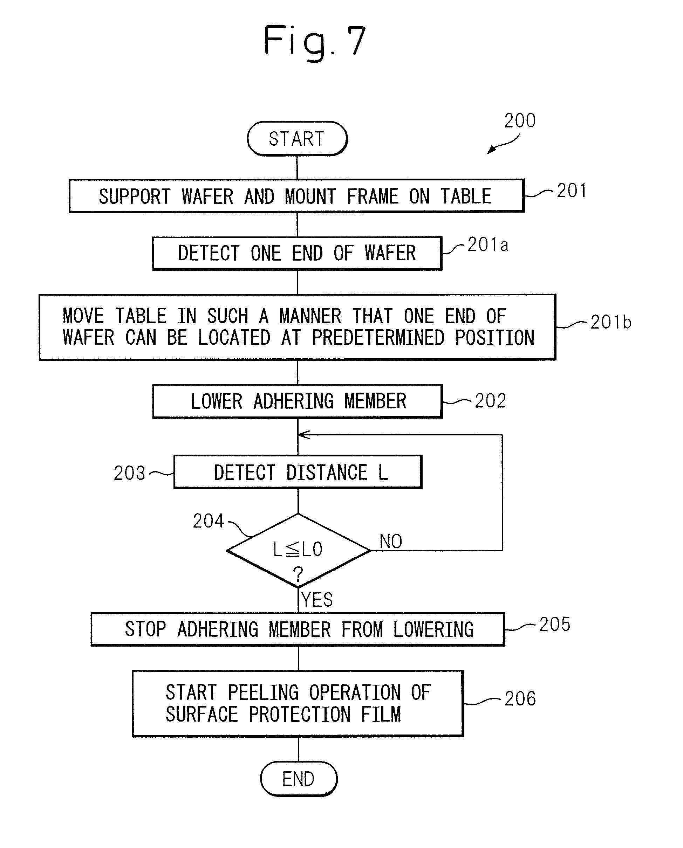

Fig. 7 is a flow chart showing an operation program of a surface protection film peeling device having a peeling tape adhering unit of the second embodiment of the present invention. Steps 201, 202, 205 and 206 of the operation program 200 shown in Fig. 7 are the same as steps 101, 102, 105 and 106 of the operation program 100 shown in Fig. 3. Therefore, explanations are omitted here.

In step 203 shown in the operation program 200, distance L between the surface protection film 11 on the wafer 20 and the adhering member 46 is detected by the distance sensor 91 shown in Fig. 1. In step 204, the thus detected distance L is compared with the predetermined value L0. The predetermined value L0 is the distance between the surface protection film 11 and the adhering member 46 at which fractures or cracks or internal strain is not generated on the wafer 20. This predetermined value L0 was found through experiments, etc., and stored in the memory of the control portion 95. Specifically, this predetermined value L0 is a value a little higher than zero. Alternatively, this predetermined value L0 may be zero.

In the case where it is determined that the detected distance L is not more than the predetermined value L0, the program proceeds to step 205 and the adhering member 46 is stopped from lowering and maintained at the same height. On the other hand, in the case where it is determined that the detected distance L is not less than the predetermined value L0, the program returns to step 203 and the processing is repeated until distance L becomes a value not more than the predetermined value L0.

In the second embodiment of the present invention, the predetermined value L0, at which no fractures or cracks are generated, is previously determined. In the case where distance L is lowered to a value not more than the predetermined value L0, the adhering member 46 is stopped from lowering, so that the pressing force given by the adhering member 46 cannot be increased anymore. Accordingly, it is clear that the same advantages as those described before can be provided in the second embodiment.

Of course, a combination of some of the embodiments described before is included in the scope of the present invention. The present invention includes a case in which an adhering member 46, the cross-section of which is circular, is used, that is, the present invention includes a case in which a so-called peeling roller is used.

## Claims

1. A peeling tape adhering method for adhering a peeling tape to a surface protection film adhered to a front surface of a wafer, comprising the steps of:
supporting the wafer on a table under the condition that the surface protection film is directed upward;
adhering the peeling tape to the surface protection film of the wafer by pressing the peeling tape onto the surface protection film when a peeling tape adhering means is lowered;
detecting pressure between the surface protection film of the wafer and the peeling tape adhering means; and
stopping the peeling tape adhering means from lowering in the case where a detected pressure value is not less than a predetermined value.

2. A peeling tape adhering device for adhering a peeling tape to a surface protection film adhered to a front surface of a wafer, comprising:
a table for supporting the wafer while the surface protection film is being directed upward;
a peeling tape adhering means for pressing and adhering the peeling tape to the surface protection film of the wafer; and
a pressure detection means for detecting pressure between the surface protection film of the wafer and the peeling tape adhering means, wherein
when the peeling tape is pressed and adhered to the surface protection film by lowering the peeling tape adhering means, in the case where a pressure value detected by the pressure detection means is not less than a predetermined value, the peeling tape adhering means is stopped from lowering.

3. A peeling tape adhering device according to claim 2, wherein the pressure detection means is incorporated into a portion of the peeling tape adhering means coming into contact with the surface protection film.

4. A peeling tape adhering device according to claim 2, wherein the pressure detection means is incorporated into a portion of the table located corresponding to the peeling tape adhering means.

5. A peeling tape adhering method for adhering a peeling tape onto a surface protection film adhered to a front surface of a wafer, comprising the steps of:
supporting the wafer on a table under the condition that the surface protection film is directed upward;
adhering the peeling tape to the surface protection film of the wafer by pressing the peeling tape onto the surface protection film when a peeling tape adhering means is lowered;
detecting a distance between the surface protection film of the wafer and the peeling tape adhering means; and
stopping the peeling tape adhering means from lowering in the case where a detected distance value is not more than a predetermined value.

6. A peeling tape adhering device for adhering a peeling tape to a surface protection film adhered to a front surface of a wafer, comprising:
a table for supporting the wafer while the surface protection film is being directed upward;
a peeling tape adhering means for pressing and adhering the peeling tape to the surface protection film of the wafer; and
a distance detection means for detecting a distance between the surface protection film of the wafer and the peeling tape adhering means, wherein
when the peeling tape is pressed and adhered onto the surface protection film by lowering the peeling tape adhering means, in the case where a distance value detected by the distance detection means is not more than a predetermined value, the peeling tape adhering means is stopped from lowering.
